(19) **Europäisches Patentamt**
**European Patent Office**
**Office européen des brevets**

(11) **EP 2 135 352 B1**

(12) **EUROPÄISCHE PATENTSCHRIFT**

(45) Veröffentlichungstag und Bekanntmachung des Hinweises auf die Patenterteilung:
**07.09.2011 Patentblatt 2011/36**

(21) Anmeldenummer: **08708058.6**

(22) Anmeldetag: **22.01.2008**

(51) Int Cl.:
***H03J 3/08*** *(2006.01)*

(86) Internationale Anmeldenummer:
**PCT/EP2008/050684**

(87) Internationale Veröffentlichungsnummer:
**WO 2008/113620 (25.09.2008 Gazette 2008/39)**

(54) **VERFAHREN ZUR REKONSTRUKTION EINES STÖRUNGSREDUZIERTEN PERIODISCHEN SPANNUNGSSIGNALS**

METHOD FOR THE RECONSTRUCTION OF A FAULT-REDUCED PERIODIC VOLTAGE SIGNAL

PROCÉDÉ POUR LA RECONSTRUCTION D'UN SIGNAL DE TENSION PÉRIODIQUE À PERTURBATION RÉDUITE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **21.03.2007 AT 4412007**

(43) Veröffentlichungstag der Anmeldung:
**23.12.2009 Patentblatt 2009/52**

(73) Patentinhaber: **Siemens Aktiengesellschaft 80333 München (DE)**

(72) Erfinder: **HALLAK, Jalal A-1220 Wien (AT)**

(74) Vertreter: **Maier, Daniel Oliver Siemens AG Postfach 22 16 34 80506 München (DE)**

(56) Entgegenhaltungen:
**EP-A- 1 047 191     DE-A1- 2 902 680**
**DE-A1- 3 029 249     DE-B3-102005 024 624**

**Beschreibung**

Die Erfindung betrifft ein Verfahren zur Rekonstruktion eines störungsreduzierten periodischen Spannungssignals, das in seiner Frequenz, Amplitude und/ oder Phasenlage einer sinusförmigen, in Frequenz, Amplitude und Phasenlage störungsbehafteten Eingangsspannung entspricht. Dabei wird davon ausgegangen, dass die Eingangsspannung aus einer sinusförmigen Grundschwingung, sowie überlagerten Störungen in Frequenz, Amplitude und Phasenlage der Grundschwingung besteht. Ein solches Verfahren kommt etwa dann zur Anwendung, wenn eine Schaltungsanordnung zu einer sinusförmigen Eingangsspannung synchron betrieben werden soll. Hierzu orientiert man sich zumeist an den Nulldurchgängen der sinusförmigen Eingangsspannung. Ein mögliches Einsatzgebiet ist etwa bei alternativen Stromerzeugungssystemen wie etwa Brennstoffzellenanlagen, Photovoltaikanlagen, oder Windkraftanlagen gegeben, bei denen netzgeführte Stromrichter aller Art, etwa Wechselrichter, zum Wechselspannungsnetz eines Stromversorgers netzkonform betrieben werden müssen.

In Anwendungen dieser Art ist man in der Regel mit störungsbehafteten Eingangsspannungen konfrontiert, so weisen etwa Netzspannungen letztgenannter Wechselspannungsnetze Störungen in Frequenz, Amplitude und/oder Phasenlage, sowie Oberwellen auf. Werden nun etwa für einen zur Netzspannung synchronen Betrieb einer Schaltungsanordnung die Nulldurchgänge der Eingangsspannung, in diesem Fall also der Netzspannung, herangezogen, so können z.B. durch überlagerte Oberwellen Nulldurchgänge detektiert werden, die nicht jenen der eigentlichen Grundschwingung entsprechen. Daraus kann ein fehlerhafter Betrieb der netzsynchronen Schaltungsanordnung resultieren, der letztendlich auch zu Fehlabschaltungen der netzsynchronen Schaltung führen kann.

In herkömmlicher Weise werden etwa hochfrequente Störungen einer Eingangsspannung, wie etwa Oberwellen, durch Tiefpassfilter beseitigt. Tiefpassfilter bewirken aber eine Phasenverschiebung der Ausgangsspannung des Tiefpassfilters im Vergleich zur Eingangsspannung, die wiederum aufgrund unbekannter Störungen in Frequenz und Phasenlage der Eingangsspannung nicht einfach korrigiert werden kann. Des Weiteren ist zu berücksichtigen, dass nicht auf ein Referenzsignal eines externes Signalgebers zurück gegriffen werden kann, um etwa die Eingangsspannung dem Referenzsignal anzupassen. Stattdessen soll die rekonstruierte Ausgangsspannung in ihrer Frequenz, Amplitude und Phasenlage der Grundschwingung der Eingangsspannung entsprechen, und nicht einem generierten Referenzsignal eines externes Signalgebers.

Aus EP1047191 A1 ist ein Bandpassfilter mit regelbarer Resonanzfrequenz bekannt, wobei durch Bestimmung der Phasendifferenzspannung von Eingangsspannung und Ausgangsspannung, eine Stellgrösse ermittelt wird, der die Resonanzfrequenz des Bandpassfilters regelt.

Es ist daher das Ziel der Erfindung, aus einer störungsbehafteten Eingangsspannung eine störungsreduzierte Ausgangsspannung zu rekonstruieren, die in ihrer Frequenz, Phasenlage und Amplitude der Grundschwingung der Eingangsspannung entspricht. Dabei soll auf externe Signalgeber verzichtet werden, aber dennoch ein möglichst einfacher Schaltungsaufbau gegeben sein.

Dieses Ziel wird durch die erfindungsgemäßen Merkmale erreicht. Die Erfindung bezieht sich dabei auf Verfahren zur Rekonstruktion eines störungsreduzierten Spannungssignals, das in seiner Frequenz, Amplitude und Phasenlage einer sinusförmigen, in Frequenz, Amplitude und/oder Phasenlage störungsbehafteten Eingangsspannung entspricht. Dabei ist erfindungsgemäß vorgesehen, dass die Eingangsspannung einem ersten Bandpassfilter mit regelbarer Resonanzfrequenz zugeführt wird, dessen Ausgangsspannung das störungsreduzierte Spannungssignal darstellt, wobei durch Bestimmung einer abgetasteten Differenzspannung von Ausgangsspannung und Eingangsspannung in den Nulldurchgängen von der positiven zur negativen Halbwelle der Ausgangsspannung jeweils eine Stellgröße mithilfe eines ersten Reglers ermittelt wird, der die Resonanzfrequenz des ersten Bandpassfilter so regelt, dass die Differenzspannung in den Nulldurchgängen verschwindet. Das erfindungsgemäße Verfahren bedient sich hierbei der Eigenschaft von Bandpassfilter, dass die Ausgangsspannung des Bandpassfilter bei Abweichungen der Frequenz der Eingangsspannung von der Resonanzfrequenz des Bandpassfilter eine Phasenverschiebung erfährt, wie noch näher ausgeführt werden wird. Die Resonanzfrequenz des ersten Bandpassfilter ist zunächst so eingestellt, dass sie der Frequenz der Eingangsspannung entspricht. Weist die Eingangsspannung nun eine Störung ihrer Frequenz auf, z.B. eine Abweichung von der vorgesehenen Netzfrequenz, sodass sie nicht mehr der Resonanzfrequenz des ersten Bandpassfilter entspricht, tritt eine Phasenverschiebung der Ausgangsspannung im Vergleich zur Eingangsspannung auf. Diese Phasenverschiebung wird erfindungsgemäß dazu verwendet, die Störung in der Frequenz der Eingangsspannung zu detektieren, nämlich durch Bestimmung der Differenzspannung von Ausgangsspannung und Eingangsspannung in den Nulldurchgängen von der positiven zur negativen Halbwelle der Ausgangsspannung, die nun ungleich Null sein wird. Die Resonanzfrequenz des ersten Bandpassfilters wird daraufhin erfindungsgemäß so geregelt, dass sie wieder der Frequenz der Eingangsspannung entspricht, also die Differenzspannung von Ausgangsspannung und Eingangsspannung in den Nulldurchgängen der Ausgangsspannung wieder verschwindet. Die Sollfrequenz der Regelung entspricht somit immer der Frequenz der Eingangsspannung, und eine Variation der Frequenz der Eingangsspannung bildet sich auch in der Frequenz der Ausgangsspannung ab. Das Ausgangssignal ist aber nach Passieren des Bandpassfilters etwa von seinen Oberwellen befreit, sodass eine zuverlässige Bestimmung der Nulldurchgänge und der Frequenz möglich ist, die genau den Nulldurchgängen und der Frequenz der Grundschwingung der Eingangsspannung entsprechen. In diesem Sinne ist auch im Folgenden von "störungsreduzierten Spannungssignalen" die Rede. Anhand einer solcherart rekonstruierten Ausgangsspannung ist aber ein netzsynchroner Betrieb einer nachfolgenden Schaltungsanordnung möglich.

Gemäß einer vorteilhaften Weiterbildung des erfindungsgemäßen Verfahrens kann weiters vorgesehen sein, dass die Bestimmung der abgetasteten Differenzspannung von Ausgangsspannung und Eingangsspannung in den Nulldurchgängen von der positiven zur negativen und von der negativen zur positiven Halbwelle der Ausgangsspannung mithilfe eines ersten Abtast-Halte-Glieds erfolgt, dessen Schaltelement durch ein Schaltsignal in den Nulldurchgängen von der positiven zur negativen und von der negativen zur positiven Halbwelle der Ausgangsspannung kurzzeitig betätigt wird, und dem die einem zweiten Bandpassfilter unterworfene Differenzspannung von Ausgangsspannung und Eingangsspannung zugeführt wird. Abtast-Halte-Glieder sind etwa aus Phasendetektoren wohlbekannt, und bestehen aus einem Schaltelement und einem Kondensator. Bei Schließen des Schaltelements wird der momentane Spannungswert auf dem Kondensator gespeichert und bleibt durch einen als Buffer wirkenden Impedanzwandler bis zum nächsten Abtastvorgang unverändert. Falls das Schaltelement durch ein Schaltsignal in den Nulldurchgängen von der positiven zur negativen und von der negativen zur positiven Halbwelle der Ausgangsspannung betätigt wird, wird somit die Differenzspannung von Ausgangsspannung und Eingangsspannung in den Nulldurchgängen der Ausgangsspannung ermittelt. Hierzu wird die Differenzspannung von Ausgangsspannung und Eingangsspannung zuvor noch einem zweiten Bandpassfilter unterworfen, da diese Differenzspannung noch alle Störungen und Oberwellen der Eingangsspannung enthält. Der so ermittelte Spannungswert bildet die Stellgröße für den ersten Regler der Resonanzfrequenz des ersten Bandpassfilter.

Ausgehend vom Schaltsignal in den Nulldurchgängen bestimmt sich die Polarität des ermittelten Spannungswerts abhängig davon, ob die Frequenz der Eingansspannung größer oder kleiner als die Resonanzfrequenz des ersten Bandbandfilters ist.

Für den Fall, dass die Frequenz der Eingangsspannung größer als die Resonanzfrequenz des ersten Bandpassfilters, und das Schaltsignal einem Nulldurchgang von der positiven zur negativen Halbwelle der Ausgangsspannung zugeordnet ist, wird ein negativer Spannungswert ermittelt. Ist das Schaltsignal einem Nulldurchgang von der negativen zur positiven Halbwelle der Ausgangsspannung zugeordnet, ist der ermittelte Spannungswert positiv.

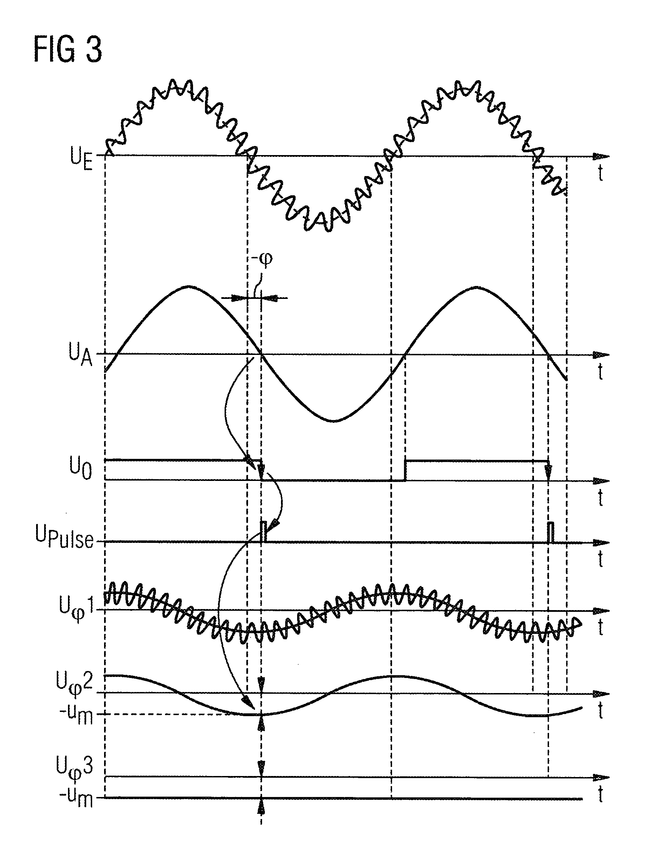

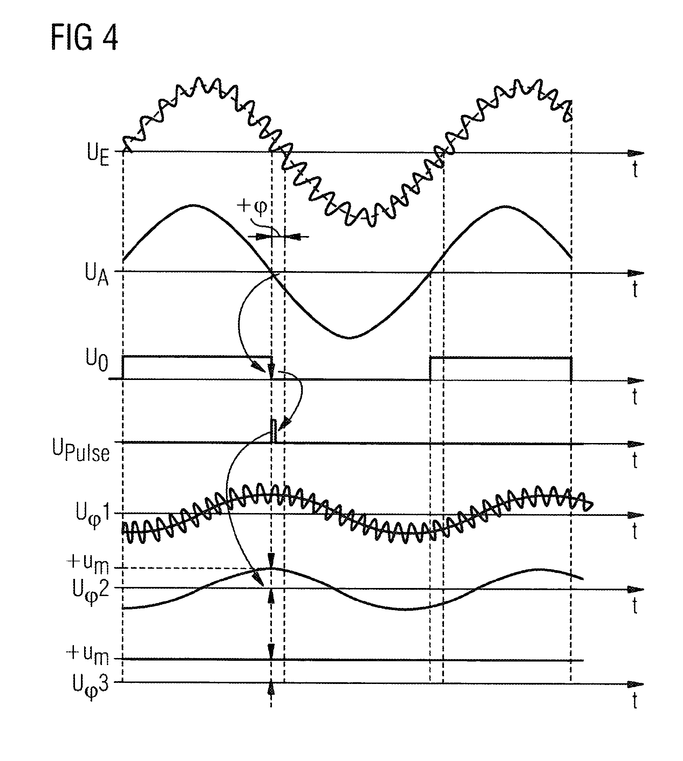

Für den Fall, dass die Frequenz der Eingangsspannung kleiner als die Resonanzfrequenz des ersten Bandpassfilters ist, vertauscht sich die Polarität des ermittelten Spannungswerts entsprechend (vgl. Fig. 3 und 4).

Das Vorzeichen der Stellgröße am Ausgang des ersten Reglers wird der Polarität des ermittelten Spannungswertes angepasst.

Aufgrund der nachfolgenden Regelung spielen eventuelle Phasenverschiebungen des Ausgangssignals des zweiten Bandpassfilters keine große Rolle. Die Resonanzfrequenz des zweiten Bandpassfilter wird somit so gewählt sein, dass sie eine um die Frequenz der zu rekonstruierenden Eingangsspannung geeignet gewählte Bandbreite aufweist. Gemäß einer vorteilhaften Ausführungsform kann für den zweiten Bandpassfilter aber auch vorgesehen sein, dass die Resonanzfrequenz des zweiten Bandpassfilters durch die Stellgröße für die Resonanzfrequenz des ersten Bandpassfilters gesteuert wird. Da aber, wie erwähnt, die Phasenverschiebung des Ausgangssignals des zweiten Bandpassfilter keine Auswirkung auf die erfindungsgemäße Regelung hat, handelt es sich hier um eine Steuerung, und nicht um eine Regelung.

Wegen der Verstärkungstoleranz des ersten Bandpassfilters wird die rekonstruierte Ausgangsspannung des ersten Bandpassfilter in der Regel eine im Vergleich zur Eingangsspannung veränderte Amplitude aufweisen. Daher ist gemäß einer bevorzugten Ausführungsform vorgesehen, dass durch Bestimmung der abgetasteten Differenzspannung von Ausgangsspannung und Eingangsspannung in den Scheitelpunkten der Ausgangsspannung eine Stellgröße für einen zweiten Regler ermittelt wird, der die Verstärkung des ersten Bandpassfilters so regelt, dass die Differenzspannung in den Scheitelpunkten der Ausgangsspannung verschwindet. Dadurch kann erreicht werden, dass die rekonstruierte Ausgangsspannung in ihrer Amplitude der Eingangsspannung entspricht. Zur Ermittlung der Stellgröße des zweiten Reglers kann wiederum vorgesehen sein, dass die Bestimmung der abgetasteten Differenzspannung von Ausgangsspannung und Eingangsspannung in den positiven oder in den negativen Scheitelpunkten der Ausgangsspannung mithilfe eines zweiten Abtast-Halte-Glieds erfolgt, dessen Schaltelement durch ein Schaltsignal in den positiven oder in den negativen Scheitelpunkten der Ausgangsspannung betätigt wird, und dem die einem dritten Bandpassfilter unterworfene Differenzspannung von Ausgangsspannung und Eingangsspannung zugeführt wird. Aufgrund der nachfolgenden Regelung spielen eventuelle Phasenverschiebungen des Ausgangssignals des dritten Bandpassfilters wiederum keine große Rolle. Die Resonanzfrequenz des dritten Bandpassfilter kann daher so gewählt sein, dass sie eine um die Frequenz der zu rekontruierenden Eingangsspannung geeignet gewählte Bandbreite aufweist.

Die Polarität des ermittelten Spannungswertes hängt vom Vorzeichen der Differenzspannung zwischen Ausgangs- und Eingangsspannung während des Auftretens des Schaltsignals in den Scheitelpunkten ab.

Für den Fall, dass das Vorzeichen der Differenzspannung positiv ist, ist auch der ermittelte Spannungswert positiv, wenn das Schaltsignal einem positiven Scheitelpunkt des Ausgangssignals des ersten Filters zugeordnet ist. Der ermittelte Spannungswert ist jedoch negativ, wenn das Schaltsignal einem negativen Scheitelpunkt des Ausgangssignals des ersten Filters zugeordnet ist.

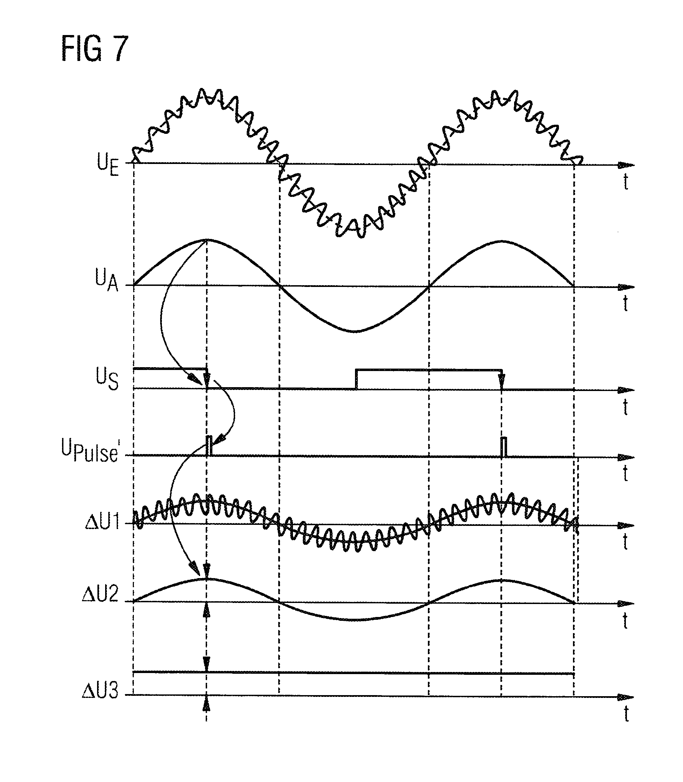

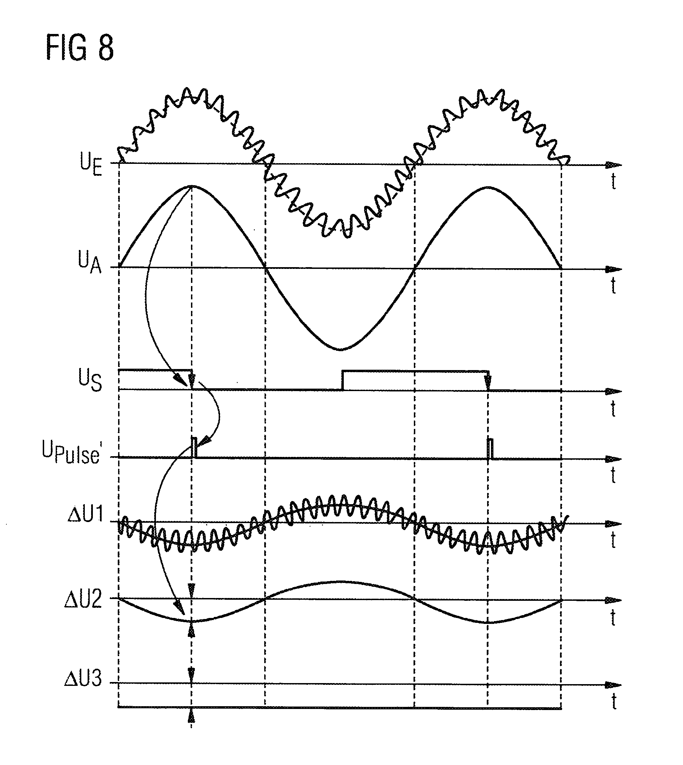

Für den Fall, dass das Vorzeichen der Differenzspannung negativ ist, vertauscht sich die Polarität des ermittelten Spannungswertes entsprechend (vgl. Fig. 7 und 8).

Das Vorzeichen der Stellgröße am Ausgang des ersten Reglers wird deshalb an die Polarität des ermittelten Spannungswertes angepasst.

In einer kombinierten Ausführungsform kann schließlich vorgesehen sein, dass die Bestimmung der abgetasteten Differenzspannung von Ausgangsspannung und Eingangsspannung in den Nulldurchgängen der Ausgangsspannung mithilfe eines ersten Abtast-Halte-Glieds erfolgt, dessen Schaltelement durch ein Schaltsignal in den Nulldurchgängen der Ausgangsspannung betätigt wird, und dem die einem zweiten Bandpassfilter unterworfene Differenzspannung von Ausgangsspannung und Eingangsspannung zugeführt wird, und wobei die Bestimmung der abgetasteten Differenzspannung von Ausgangsspannung und Eingangsspannung in den Scheitelpunkten der Ausgangsspannung mithilfe eines zweiten Abtast-Halte-Glieds erfolgt, dessen Schaltelement durch ein Schaltsignal in den Scheitelpunkten der Ausgangsspannung betätigt wird, und dem die dem zweiten Bandpassfilter unterworfene Differenzspannung von Ausgangsspannung und Eingangsspannung zugeführt wird.

Die Erfindung wird im Folgenden anhand bevorzugter Ausführungsformen mithilfe der beiliegenden Figuren näher erläutert. Es zeigen hierbei die

Fig. 1 eine Darstellung zur Erläuterung der Problematik einer fehlerhaften Nulldurchgangserkennung bei einer gestörten Eingangsspannung,

Fig. 2 eine Darstellung des erfindungsgemäßen Verfahrens zur Regelung der Resonanzfrequenz des ersten Bandpassfilter,

Fig. 3 eine Darstellung der Signalformen im erfindungsgemäßen Verfahren, wenn die Frequenz der Eingangsspannung größer ist als die Resonanzfrequenz des ersten Bandpassfilter,

Fig. 4 eine Darstellung der Signalformen im erfindungsgemäßen Verfahren, wenn die Frequenz der Eingangsspannung kleiner ist als die Resonanzfrequenz des ersten Bandpassfilter,

Fig. 5 eine Darstellung der Signalformen im erfindungsgemäßen Verfahren, wenn die Frequenz der Eingangsspannung der Resonanzfrequenz des ersten Bandpassfilter entspricht,

Fig. 6 eine Darstellung einer Weiterbildung des erfindungsgemäßen Verfahrens zur Regelung der Amplitude der rekonstruierten Ausgangsspannung mithilfe des ersten Bandpassfilter,

Fig. 7 eine Darstellung der Signalformen bei der Weiterbildung des erfindungsgemäßen Verfahrens gemäß Fig. 6, wenn die Amplitude der Eingangsspannung größer ist als die Amplitude der Ausgangsspannung, und

Fig. 8 eine Darstellung der Signalformen bei der Weiterbildung des erfindungsgemäßen Verfahrens gemäß Fig. 6, wenn die Amplitude der Eingangsspannung kleiner ist als die Amplitude der Ausgangsspannung,

Fig. 9 eine Darstellung einer Weiterbildung des erfindungsgemäßen Verfahrens zur gleichzeitigen Regelung der Resonanzfrequenz und der Amplitude der rekonstruierten Ausgangsspannung mithilfe eines ersten Bandpassfilter und eines zweiten Bandpassfilter.

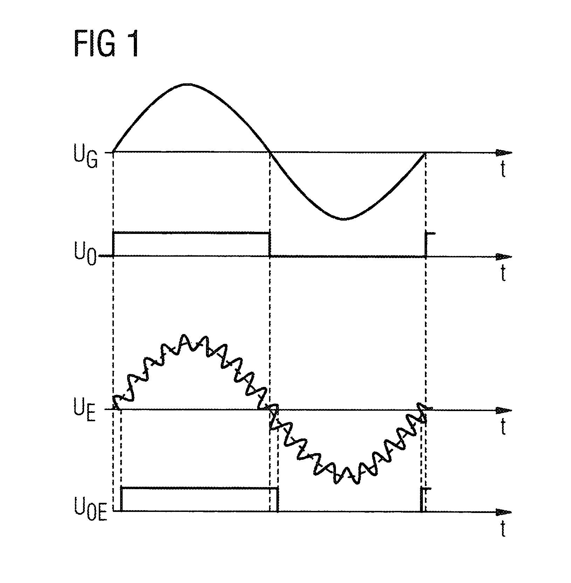

In der Fig. 1 wird zunächst die Problematik einer fehlerhaften Nulldurchgangserkennung bei einer gestörten Eingangsspannung $U_E$, bei der es sich etwa um die Netzspannung eines Stromversorgers handelt, zu der eine nachfolgende Schaltungsanordnung netzsynchron zu betreiben ist, erläutert. Eine störungsfreie Eingangsspannung besteht zunächst lediglich aus einer Grundschwingung $U_G$ (siehe oberste Funktion der Fig. 1), bei der die Nulldurchgangserkennung kein Problem darstellt. Bei einer gestörten Eingangsspannung $U_E$ allerdings, die in dem gezeigten Beispiel etwa mit Oberwellen überlagert ist, kann es zu einer fehlerhaften Nulldurchgangserkennung kommen, da aufgrund der Störungen die Nulllinie früher oder später im Vergleich zur Grundschwingung $U_G$ überschritten wird (siehe untere Funktion der Fig. 1). Zur Filterung der hochfrequenten Störungen der Eingangsspannung $U_E$ könnte etwa ein Tiefpassfilter verwendet werden, der aber eine Phasenverschiebung der Ausgangsspannung $U_A$ des Tiefpassfilters im Vergleich zur Eingangsspannung bewirkt, die wiederum aufgrund unbekannter Störungen in Frequenz und Phasenlage der Eingangsspannung $U_E$ nicht einfach korrigiert werden kann.

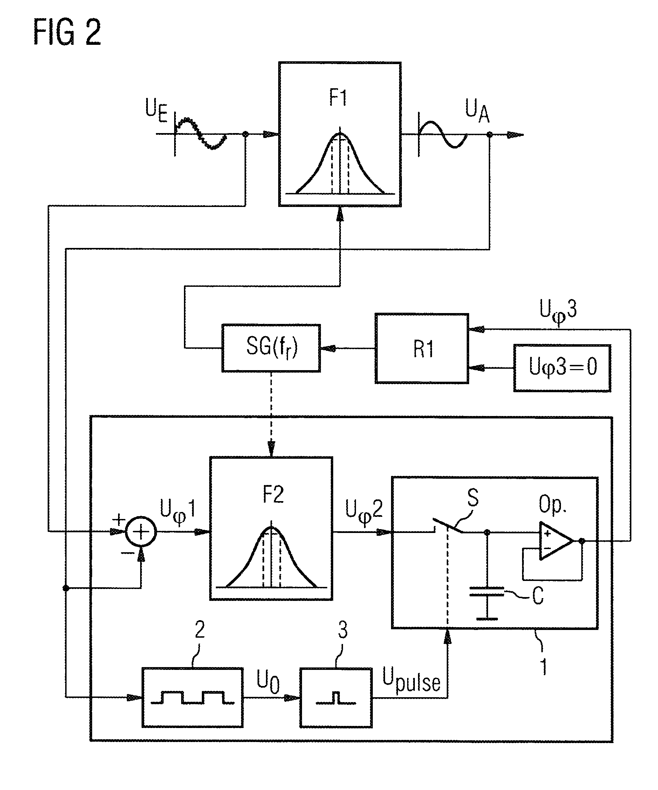

Daher wird ein erfindungsgemäßes Verfahren vorgeschlagen, das anhand der Fig. 2 erläutert wird. Die Fig. 2 zeigt zunächst ein erstes Bandpassfilter F1, dem eine störungsbehaftete Eingangsspannung $U_E$ zugeführt wird. Das erste Bandpassfilter F1 weist eine regelbare Resonanzfrequenz $f_r$ auf, wobei die Resonanzfrequenz

$f_r$ etwa bei einer Netzspannung mit 50 Hz als Eingangsspannung $U_E$ im Bereich von 45 Hz bis 55 Hz regelbar ist. Am Ausgang des ersten Bandpassfilter F1 ist die Ausgangsspannung $U_A$ dargestellt, die in Folge der Wirkung des ersten Bandpassfilter F1 von hochfrequenten Anteilen befreit und somit störungsreduziert ist.

Wie bereits erwähnt wurde, bedient sich das erfindungsgemäße Verfahren nun der Eigenschaft von Bandpassfilter, dass die Ausgangsspannung $U_A$ des ersten Bandpassfilter F1 bei Abweichungen der Frequenz der Eingangsspannung $U_E$ von der Resonanzfrequenz $f_r$ des ersten Bandpassfilter F1 eine Phasenverschiebung erfährt, die sich wie folgt verhält:

$$\varphi = \arctan[Q*(1-\Omega^2)/\Omega],$$

wobei $\varphi$ die Phasenverschiebung ist, Q die Güte des ersten Bandpassfilter F1, und $\Omega$ der Quotient aus Frequenz der Eingangsspannung $U_E$ und der Resonanzfrequenz $f_r$ des ersten Bandpassfilter F1.

Die Resonanzfrequenz $f_r$ des ersten Bandpassfilter F1 ist dabei zunächst so eingestellt, dass sie der Frequenz der Eingangsspannung $U_E$ entspricht. Weist die Eingangsspannung $U_E$ nun eine Störung ihrer Frequenz (z.B. Abweichung von der Netzfrequenz) auf, sodass sie nicht mehr der Resonanzfrequenz $f_r$ des ersten Bandpassfilter F1 entspricht, tritt eine Phasenverschiebung $\varphi$ der Ausgangsspannung $U_A$ im Vergleich zur Eingangsspannung $U_E$ auf. Diese Phasenverschiebung $\varphi$ wird erfindungsgemäß dazu verwendet, die Störung in der Frequenz der Eingangsspannung $U_E$ zu detektieren, nämlich durch Bestimmung der abgetasteten Differenzspannung $U_\varphi 3$ von Ausgangsspannung $U_A$ und der Eingangsspannung $U_E$ in den Nulldurchgängen der Ausgangsspannung $U_A$, die nun ungleich Null sein wird. Hierzu wird zunächst die Differenzspannung $U_\varphi 1$ von Ausgangsspannung $U_A$ und Eingangsspannung $U_E$ ermittelt.

Die Bestimmung der abgetasteten Differenzspannung $U_\varphi 3$ von Ausgangsspannung $U_A$ und Eingangsspannung $U_E$ in den Nulldurchgängen der Ausgangsspannung $U_A$ erfolgt etwa mithilfe eines ersten Abtast-Halte-Glieds 1, dessen Schaltelement S durch ein Schaltsignal $U_{Pulse}$ in den Nulldurchgängen der Ausgangsspannung $U_A$ betätigt wird, und dem die einem zweiten Bandpassfilter F2 unterworfene Differenzspannung $U_\varphi 2$ von Ausgangsspannung $U_A$ und Eingangsspannung $U_E$ zugeführt wird.

Abtast-Halte-Glieder 1 sind etwa aus Phasendetektoren wohlbekannt, und bestehen aus einem Schaltelement S und einem Kondensator C. Des Weiteren weist sie gemäß Fig. 2 einen als Buffer ausgebildeten Impedanzwandler Op auf. Bei Schließen des Schaltelements S wird der momentane Spannungswert der dem zweiten Bandpassfilter F2 unterworfenen Differenzspannung $U_\varphi 2$ auf dem Kondensator C gespeichert und bleibt durch den als Buffer ausgebildeten Impedanzwandler Op bis zum nächsten Abtastvorgang unverändert.

Zur Betätigung des Schaltelements S ist ein Schaltsignal $U_{Pulse}$ erforderlich, das etwa mithilfe einer Nulldurchgangserkennung 2 und einem Mono-Flip-Flop 3, das z.B. Pulse mit einer Dauer, die von dem Kondensator C und von dem Typ des Abtast-Halte-Glieds 1 abhängig ist, liefert, ermittelt werden kann.

Da das Schaltelement S durch das Schaltsignal $U_{Pulse}$ in den Nulldurchgängen der Ausgangsspannung $U_A$ betätigt wird, wird somit die abgetastete Differenzspannung $U_\varphi 3$ von Ausgangsspannung $U_A$ und Eingangsspannung $U_E$ in den Nulldurchgängen der Ausgangsspannung $U_A$ ermittelt. Der so ermittelte Spannungswert wird zur Ermittlung der Stellgröße $SG(f_r)$ für den ersten Regler R1 der Resonanzfrequenz $f_r$ des ersten Bandpassfilter F1 verwendet, indem er mit dem Sollwert $U_\varphi 3 = 0$ verglichen wird.

Die Resonanzfrequenz $f_{r2}$ des zweiten Bandpassfilter F2 wird so gewählt sein, dass sie eine um die Frequenz der zu rekontruierenden Eingangsspannung $U_E$ geeignet gewählte Bandbreite B aufweist, also etwa eine Bandbreite von 10 Hz bei einer Resonanzfrequenz von 50 Hz im Falle einer Netzspannung als Eingangsspannung $U_E$. Gemäß einer vorteilhaften Ausführungsform kann für den zweiten Bandpassfilter F2 aber auch vorgesehen sein, dass die Resonanzfrequenz $f_{r2}$ des zweiten Bandpassfilters F2 durch die Stellgröße $SG(f_r)$ für die Resonanzfrequenz $f_r$ des ersten Bandpassfilters F1 gesteuert wird. Da aber, wie erwähnt, die Phasenverschiebung des Ausgangssignals $U_\varphi 2$ des zweiten Bandpassfilter F2 keine Auswirkung auf die erfindungsgemäße Regelung hat, spielen eventuelle Phasenverschiebungen des Ausgangssignals $U_\varphi 2$ des zweiten Bandpassfilters F2 keine große Rolle.

Die Resonanzfrequenz $f_r$ des ersten Bandpassfilters F1 wird daraufhin erfindungsgemäß so geregelt, dass sie wieder der Frequenz der Eingangsspannung $U_E$ entspricht, also die abgetastete Differenzspannung $U_\varphi 3$ von Ausgangsspannung $U_A$ und Eingangsspannung $U_E$ in den Nulldurchgängen der Ausgangsspannung $U_A$ wieder verschwindet.

Die Fig. 3 zeigt eine Darstellung der Signalformen für

-) die Eingangsspannung $U_E$,

-) die Ausgangsspannung $U_A$ nach dem ersten Bandpassfilter F1,

-) das Signal $U_\varnothing$ nach der Nulldurchgangserkennung 2,

-) das Schaltsignal $U_{Pulse}$ nach dem Mono-Flip-Flop 3,

-) die Differenzspannung $U_\varphi 1$ von Ausgangsspannung $U_A$ und Eingangsspannung $U_E$,

-) die dem zweiten Bandpassfilter F2 unterworfene Differenzspannung $U_\varphi 2$, und

-) die abgetastete Differenzspannung $U_\varphi 3$ von Ausgangsspannung $U_A$ und Eingangsspannung $U_E$ in den Nulldurchgängen der Ausgangsspannung $U_A$,

und zwar für jenen Fall, in dem die Frequenz der Eingangsspannung $U_E$ größer ist als die Resonanzfrequenz $f_r$ des ersten Bandpassfilter F1. Die Ausgangsspannung $U_A$ nach dem ersten Bandpassfilter F1 weist zunächst eine Phasenverschiebung φ auf. Der Nulldurchgangserkennung 2 wird, wie auch der Fig. 2 entnommen werden kann, die Ausgangsspannung $U_A$ zugeführt, sodass die Nulldurchgänge der Ausgangsspannung $U_A$ noch nicht jenen der Eingangsspannung $U_E$ entsprechen. Anhand der Nulldurchgänge der Ausgangsspannung $U_A$ wird das Schaltsignal $U_{Pulse}$ ermittelt. Des Weiteren ist ersichtlich, dass die Differenzspannung $U_φ1$ von Ausgangsspannung $U_A$ und Eingangsspannung $U_E$ noch alle Störungen bzw. Oberwellen der Eingangsspannung $U_E$ enthält, wobei die hochfrequenten Störungen nach Passieren des zweiten Bandpassfilter F2 entfernt werden, und sich die dem zweiten Bandpassfilter F2 unterworfene Differenzspannung $U_φ2$ ergibt. Durch das Abtast-Halte-Glied 1 wird die Differenzspannung $U_φ3$ von Ausgangsspannung $U_A$ und Eingangsspannung $U_E$ in den Nulldurchgängen von der positiven zur negativen Halbwelle der Ausgangsspannung $U_A$ ermittelt, die in der Fig. 3 als $-U_m$ eingezeichnet ist. Der so ermittelte Spannungswert $-U_m$ wird in weiterer Folge zur Ermittlung der Stellgröße SG ($f_r$) für den ersten Regler R1 der Resonanzfrequenz $f_r$ des ersten Bandpassfilter F1 verwendet, indem er mit dem Sollwert $U_φ3=0$ verglichen wird.

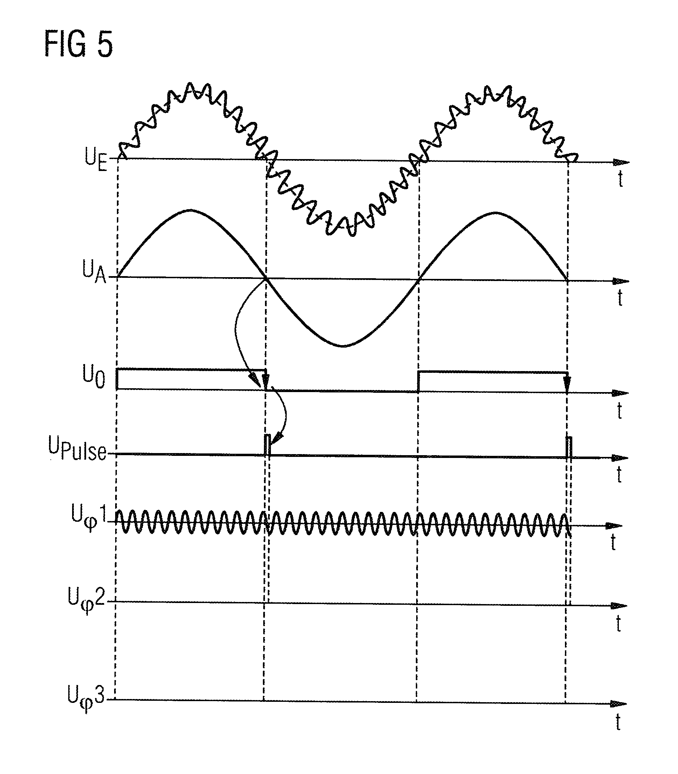

Die Fig. 4 zeigt eine zur Fig. 3 analoge Darstellung der Signalformen im erfindungsgemäßen Verfahren, wenn die Frequenz der Eingangsspannung $U_E$ kleiner ist als die Resonanzfrequenz $f_r$ des ersten Bandpassfilter F1. Dabei wird durch das Abtast-Halte-Glied 1 der Wert $+U_m$ (vgl. Fig. 4) der Differenzspannung $U_φ3$ zwischen Ausgangsspannung $U_A$ und Eingangsspannung $U_E$ in den Nulldurchgängen von der positiven zur negativen Halbwelle der Ausgangsspannung $U_A$ ermittelt. Fig. 5 zeigt den Fall, dass die Frequenz der Eingangsspannung $U_E$ der Resonanzfrequenz $f_r$ des ersten Bandpassfilter F1 entspricht. Im letzteren Fall zeigt sich, dass die Differenzspannung $U_φ3$ von Ausgangsspannung $U_A$ und Eingangsspannung $U_E$ in den Nulldurchgängen der Ausgangsspannung $U_A$ verschwindet, und somit auch keine Stellgröße SG($f_r$) für den ersten Regler R1 der Resonanzfrequenz $f_r$ des ersten Bandpassfilter F1 ermittelt wird. Wie bereits erwähnt, wird der Abtastvorgang in den Nulldurchgängen von der negativen zur positiven Halbwelle der Ausgangsspannung $U_A$ durchgeführt. Dabei ist zu berücksichtigen, dass das Vorzeichen der Stellgröße am Ausgang des ersten Reglers an die Polarität des ermittelten Spannungswertes $U_φ3$ angepasst wird.

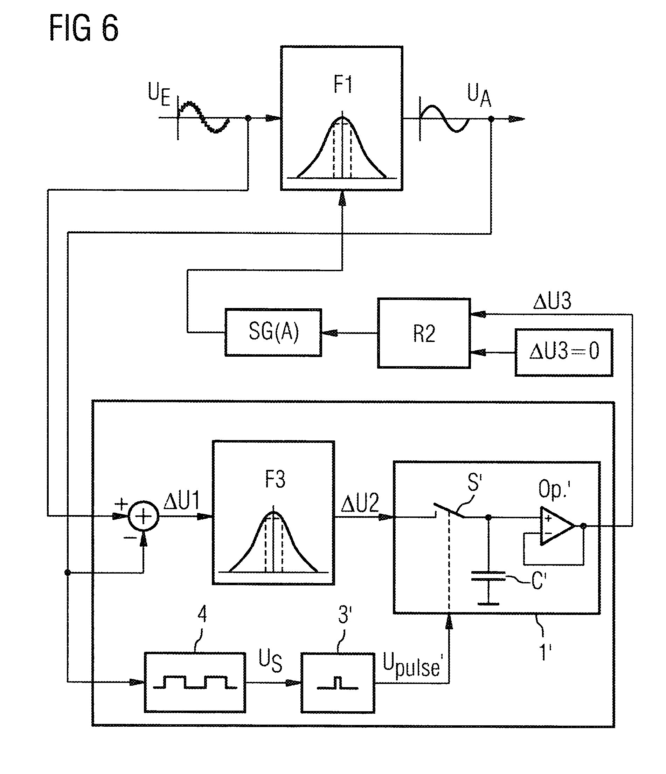

In der Fig. 6 ist schließlich eine Darstellung einer Weiterbildung des erfindungsgemäßen Verfahrens zur Regelung der Amplitude der rekonstruierten Ausgangsspannung $U_A$ zum Ausgleich der Verstärkertoleranz des ersten Bandpassfilters gezeigt. Wie bereits erwähnt wurde, wird die rekonstruierte Ausgangsspannung $U_A$ des ersten Bandpassfilter F1 in der Regel eine im Vergleich zur Eingangsspannung $U_E$ veränderte Amplitude aufweisen. Daher ist gemäß einer bevorzugten Ausführungsform vorgesehen, dass durch Bestimmung der abgetasteten Differenzspannung $\Delta U3$ von Ausgangsspannung $U_A$ und Eingangsspannung $U_E$ in den positiven Scheitel punkten der Ausgangsspannung $U_A$ eine Stellgröße SG(A) mithilfe eines zweiten Reglers R2 ermittelt wird, der die Verstärkung des ersten Bandpassfilters F1 so regelt, dass die abgetastete Differenzspannung $\Delta U3$ in den positiven Scheitelpunkten der Ausgangsspannung $U_A$ verschwindet. Dadurch kann erreicht werden, dass die rekonstruierte Ausgangsspannung $U_A$ in ihrer Amplitude der Eingangsspannung $U_E$ entspricht. Hierzu wird zunächst die Differenzspannung $\Delta U1$ von Ausgangsspannung $U_A$ und Eingangsspannung $U_E$ ermittelt.

Die Bestimmung der abgetasteten Differenzspannung $\Delta U3$ von Ausgangsspannung $U_A$ und Eingangsspannung $U_E$ in den positiven Scheitelpunkten der Ausgangsspannung $U_A$ erfolgt etwa mithilfe eines zweiten Abtast-Halte-Glieds 1', dessen Schaltelement S durch ein Schaltsignal $U_{Pulse}$' in den Scheitelpunkten der Ausgangsspannung $U_A$ betätigt wird, und dem die einem dritten Bandpassfilter F3 unterworfene Differenzspannung $\Delta U2$ von Ausgangsspannung $U_A$ und Eingangsspannung $U_E$ zugeführt wird.

Zur Betätigung des Schaltelements S' ist ein Schaltsignal $U_{Pulse}$' erforderlich, das etwa mithilfe einer Scheitelwerterkennung 4 und einem Mono-Flip-Flop 3', das z.B. Pulse mit einer Dauer, abhängig vom Kondensator C' und vom Typ des Abtast-Halte-Gliedes 1', liefert, ermittelt werden kann. Da das Schaltelement S' durch das Schaltsignal $U_{Pulse}$' in den positiven Scheitelpunkten der Ausgangsspannung $U_A$ betätigt wird, wird somit die Differenzspannung $\Delta U3$ von Ausgangsspannung $U_A$ und Eingangsspannung $U_E$ in den positiven Scheitelpunkten der Ausgangsspannung $U_A$ ermittelt. Der so ermittelte Spannungswert wird zur Ermittlung der Stellgröße SG (A) mithilfe des zweiten Reglers R2 für die Verstärkung des ersten Bandpassfilter F1 verwendet, indem er mit dem Sollwert $\Delta U3=0$ verglichen wird.

Die Resonanzfrequenz $f_{r3}$ des dritten Bandpassfilter F3 wird wiederum so gewählt sein, dass sie eine um die Frequenz der zu rekontruierenden Eingangsspannung $U_E$ geeignet gewählte Bandbreite B aufweist, also etwa eine Bandbreite von 10 Hz bei einer Resonanzfrequenz von 50 Hz im Falle einer Netzspannung als Eingangsspannung $U_E$.

Die Fig. 7 zeigt eine Darstellung der Signalformen bei der Weiterbildung des erfindungsgemäßen Verfahrens gemäß Fig. 6, wenn die Amplitude der Eingangsspannung $U_E$ größer ist als die Amplitude der Ausgangsspannung $U_A$. Hierbei sind folgende Signalformen ersichtlich:

-) die Eingangsspannung $U_E$,

-) die Ausgangsspannung $U_A$ nach dem ersten Bandpassfilter F1,

-) das Signal $U_S$ nach der Scheitelwerterkennung 4,

-) das Schaltsignal $U_{Pulse}$' nach dem Mono-Flip-Flop 3',

-) die Differenzspannung $\Delta U1$ von Ausgangsspannung $U_A$ und Eingangsspannung $U_E$,

-) die dem zweiten Bandpassfilter F2 unterworfene Differenzspannung $\Delta U2$, und

-) die abgetasteten Differenzspannung $\Delta U3$ von Ausgangsspannung $U_A$-und Eingangsspannung $U_E$ in den positiven Scheitelwerten der Ausgangsspannung $U_A$.

Die Ausgangsspannung $U_A$ nach dem ersten Bandpassfilter F1 weist zunächst eine im Vergleich zur Eingangsspannung $U_E$ unterschiedliche Amplitude auf. Der Scheitelwerterkennung 4 wird, wie auch der Fig. 6 entnommen werden kann, die Ausgangsspannung $U_A$ zugeführt, wobei die Scheitelwerte der Ausgangsspannung $U_A$ noch nicht jenen der Eingangsspannung $U_E$ entsprechen. Anhand der Lage der positiven Scheitelwerte bei der Ausgangsspannung $U_A$ wird das Schaltsignal $U_{Pulse}$' ermittelt. Des Weiteren ist ersichtlich, dass die Differenzspannung $\Delta U1$ von Ausgangsspannung $U_A$ und Eingangsspannung $U_E$ noch alle Störungen bzw. Oberwellen der Eingangsspannung $U_E$ enthält, wobei die hochfrequenten Störungen nach Passieren des dritten Bandpassfilter F3 entfernt werden, und sich die dem dritten Bandpassfilter F3 unterworfene Differenzspannung $\Delta U2$ ergibt. Durch das Abtast-Halte-Glied 1' wird die Differenzspannung $\Delta U3$ von Ausgangsspannung $U_A$ und Eingangsspannung $U_E$ in den positiven Scheitelwerten der Ausgangsspannung $U_A$ ermittelt. Der so ermittelte abgetastete Spannungswert $\Delta U3$ wird in weiterer Folge zur Ermittlung der Stellgröße SG(A) für den zweiten Regler R2 für die Verstärkung des ersten Bandpassfilter F1 verwendet, indem er mit dem Sollwert $\Delta U3=0$ verglichen wird.

Die Fig. 8 zeigt schließlich eine Darstellung der Signalformen bei der Weiterbildung des erfindungsgemäßen Verfahrens gemäß Fig. 6, wenn die Amplitude der Eingangsspannung $U_E$ kleiner ist als die Amplitude der Ausgangsspannung $U_A$.

Wie bereits erwähnt, kann der Abtastvorgang auch in den negativen Scheitelwerten der Ausgangsspannung $U_A$ durchgeführt werden. Dabei ist zu berücksichtigen, dass das Vorzeichen der Stellgröße am Ausgang des zweiten Reglers an die Polarität des ermittelten Spannungswertes $\Delta U3$ angepasst werden muss.

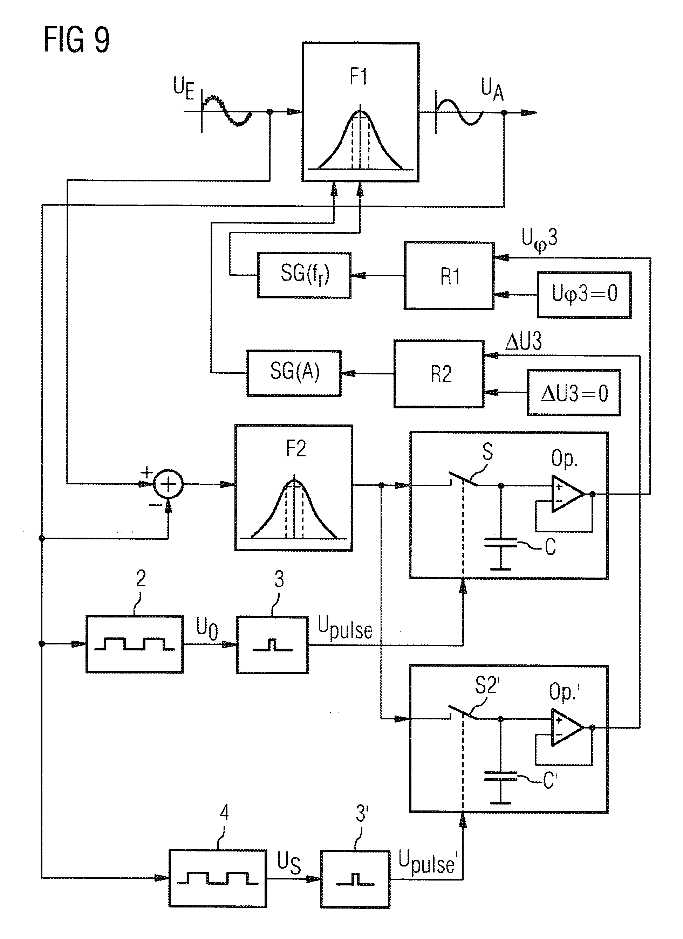

Fig. 9 zeigt eine Weiterbildung des erfindungsgemäßen Verfahrens zur Regelung der Resonanzfrequenz $f_r$ des ersten Bandpassfilters. Dabei ist ein zweiter Bandpassfilter F2 vorgesehen, welcher sowohl mit einem ersten Abtast-Halte-Glied 1 als auch einem zweiten Abtast-Halte-Glied 1' verbunden ist. Das erste Abtast-Halte-Glied 1 liefert die Differenzspannung $U_\varphi 3$ zwischen Ausgangsspannung $U_A$ und Eingangsspannung $U_E$ beim Nulldurchgang an den ersten Regler R1. Das zweite Abtast-Halte-Glied 1' liefert die Differenzspannung $\Delta U3$ zwischen Ausgangsspannung $U_A$ und Eingangsspannung $U_E$ beim Scheitelpunkt an einen zweiten Regler R2.

Somit wird mithilfe des erfindungsgemäßen Verfahrens aus einer störungsbehafteten Eingangsspannung $U_E$ eine störungsreduzierte Ausgangsspannung $U_A$ rekonstruiert, die in ihrer Frequenz, Phasenlage und Amplitude der Grundschwingung $U_G$ der Eingangsspannung $U_E$ entspricht. Dabei wird auf externe Signalgeber verzichtet, aber dennoch ein möglichst einfacher Schaltungsaufbau erreicht.

**Patentansprüche**

1. Verfahren zur Rekonstruktion eines störungsreduzierten Spannungssignals, das in seiner Frequenz, Amplitude und Phasenlage einer sinusförmigen, in Frequenz, Amplitude und/oder Phasenlage störungsbehafteten Eingangsspannung ($U_E$) entspricht, wobei die Eingangsspannung ($U_E$) einem ersten Bandpassfilter (F1) mit regelbarer Resonanzfrequenz ($f_r$) zugeführt wird, dessen Ausgangsspannung ($U_A$) das störungsreduzierte Spannungssignal darstellt, **dadurch gekennzeichnet, dass** durch Bestimmung einer abgetasteten Differenzspannung ($U_\varphi 3$) von Ausgangsspannung ($U_A$) und Eingangsspannung ($U_E$) in den Nulldurchgängen der Ausgangsspannung ($U_A$) jeweils eine Stellgröße ($SG(f_r)$) für einen ersten Regler (R1) ermittelt wird, der die Resonanzfrequenz ($f_r$) des ersten Bandpassfilter (F1) so regelt, dass die abgetastete Differenzspannung ($U_\varphi 3$) in den Nulldurchgängen verschwindet.

2. Verfahren nach Anspruch 1, **dadurch gekennzeichnet, dass** die Bestimmung der abgetasteten Differenzspannung ($U_\varphi 3$) von Ausgangsspannung ($U_A$) und Eingangsspannung ($U_E$) in den Nulldurchgängen der Ausgangsspannung ($U_A$) mithilfe eines ersten Abtast-Halte-Glieds (1) erfolgt, dessen Schaltelement (S) durch ein Schaltsignal ($U_{Pulse}$) in den Nulldurchgängen der Ausgangsspannung ($U_A$) betätigt wird, und dem die einem zweiten Bandpassfilter (F2) unterworfene Differenzspannung ($U_\varphi 2$) von Ausgangsspannung ($U_A$) und Eingangsspannung ($U_E$) zugeführt wird.

3. Verfahren nach Anspruch 2, **dadurch gekennzeichnet, dass** die Resonanzfrequenz ($f_{r2}$) des zweiten Bandpassfilters (F2) durch die Stellgröße ($SG(f_r)$) für die Resonanzfrequenz ($f_r$) des ersten Bandpassfilters (F1) gesteuert wird.

4. Verfahren nach einem der Ansprüche 1 bis 3, **dadurch gekennzeichnet, dass** durch Bestimmung der abgetasteten Differenzspannung ($\Delta U3$) von Ausgangsspannung ($U_A$) und Eingangsspannung (U_E) in den Scheitelpunkten der Ausgangsspannung (U_A) eine Stellgröße (SG(A)) für einen zweiten Regler (R2) ermittelt wird, der die Verstärkung des ersten Bandpassfilters (F1) so regelt, dass die abgetastete Differenzspannung (ΔU3) in den Scheitelpunkten der Ausgangsspannung (U_A) verschwindet.

5. Verfahren nach Anspruch 4,
**dadurch gekennzeichnet, dass** die Bestimmung der abgetasteten Differenzspannung (ΔU3) von Ausgangsspannung (U_A) und Eingangsspannung (U_E) in den Scheitelpunkten der Ausgangsspannung (U_A) mithilfe eines zweiten Abtast-Halte-Glieds (1') erfolgt, dessen Schaltelement (S) durch ein Schaltsignal (U_{Pulse'}) in den Scheitelpunkten der Ausgangsspannung (U_A) betätigt wird, und dem die einem dritten Bandpassfilter (F3) unterworfene Differenzspannung (ΔU2) von Ausgangsspannung (U_A) und Eingangsspannung (U_E) zugeführt wird.

6. Verfahren nach Anspruch 1 und 4, **dadurch gekennzeichnet, dass** die Bestimmung der abgetasteten Differenzspannung (U_φ3) von Ausgangsspannung (U_A) und Eingangsspannung (U_E) in den Nulldurchgängen der Ausgangsspannung (U_A) mithilfe eines ersten Abtast-Halte-Glieds (1) erfolgt, dessen Schaltelement (S) durch ein Schaltsignal (U_{Pulse}) in den Nulldurchgängen der Ausgangsspannung (U_A) betätigt wird, und dem die einem zweiten Bandpassfilter (F2) unterworfene Differenzspannung (U_φ2) von Ausgangsspannung (U_A) und Eingangsspannung (U_E) zugeführt wird, und wobei die Bestimmung der abgetasteten Differenzspannung (ΔU3) von Ausgangsspannung (U_A) und Eingangsspannung (U_E) in den Scheitelpunkten der Ausgangsspannung (U_A) mithilfe eines zweiten Abtast-Halte-Glieds (1') erfolgt, dessen Schaltelement (S) durch ein Schaltsignal (U_{Pulse'}) in den Scheitelpunkten der Ausgangsspannung (U_A) betätigt wird, und dem die dem zweiten Bandpassfilter (F2) unterworfene Differenzspannung (ΔU2) von Ausgangsspannung (U_A) und Eingangsspannung (U_E) zugeführt wird.

**Claims**

1. Method for reconstructing a noise-reduced voltage signal corresponding in frequency, amplitude and phase to a sinusoidal input voltage (U_E) affected by frequency, amplitude and/or phase noise, wherein the input voltage (U_E) is fed to a first bandpass filter (F1) with variable resonant frequency (f_r) whose output voltage (U_A) represents the noise-reduced voltage signal, **characterised in that** a manipulated variable (SG(f_r)) for a first controller (R1) is ascertained in each case by determining a sampled difference voltage (U_φ3) between output voltage (U_A) and input voltage (U_E) at the zero crossings of the output voltage (U_A), said first controller (R1) regulating the resonant frequency (f_r) of the first bandpass filter (F1) such that the sampled difference voltage (U_φ3) at the zero crossings disappears.

2. Method according to claim 1, **characterised in that** the sampled difference voltage (U_φ3) between output voltage (U_A) and input voltage (U_E) at the zero crossings of the output voltage (U_A) is determined with the aid of a first sample-and-hold element (1) whose switching element (S) is actuated by means of a switching signal (U_{Pulse}) at the zero crossings of the output voltage (U_A) and to which is fed the difference voltage (U_φ2) between output voltage (U_A) and input voltage (U_E) which is subjected to a second bandpass filter (F2).

3. Method according to claim 2, **characterised in that** the resonant frequency (f_{r2}) of the second bandpass filter (F2) is controlled by the manipulated variable (SG(f_r)) for the resonant frequency (f_r) of the first bandpass filter (F1).

4. Method according to one of claims 1 to 3, **characterised in that** a manipulated variable (SG (A)) for a second controller (R2) is ascertained by determining the sampled difference voltage (ΔU3) between output voltage (U_A) and input voltage (U_E) at the peaks of the output voltage (U_A), said second controller (R2) regulating the gain of the first bandpass filter (F1) such that the sampled difference voltage (ΔU3) at the peaks of the output voltage (U_A) disappears.

5. Method according to claim 4,
**characterised in that** the sampled difference voltage (ΔU3) between output voltage (U_A) and input voltage (U_E) is determined at the peaks of the output voltage (U_A) with the aid of a second sample-and-hold element (1') whose switching element (S) is actuated by means of a switching signal (U_{Pulse'}) at the peaks of the output voltage (U_A) and to which is fed the difference voltage (ΔU2) between output voltage (U_A) and input voltage (U_E) which is subjected to a third bandpass filter (F3).

6. Method according to claim 1 and 4, **characterised in that** the sampled difference voltage (U_φ3) between output voltage (U_A) and input voltage (U_E) at the zero crossings of the output voltage (U_A) is determined with the aid of a first sample-and-hold element (1) whose switching element (S) is actuated by means of a switching signal (U_{Pulse}) at the zero crossings of the output voltage (U_A) and to which is fed the difference voltage (U_φ2) between output voltage (U_A) and input voltage (U_E) which is subjected to a second bandpass filter (F2), and wherein the sampled difference voltage ($\Delta U3$) between output voltage ($U_A$) and input voltage ($U_E$) is determined at the peaks of the output voltage ($U_A$) with the aid of a second sample-and-hold element (1') whose switching element (S) is actuated by means of a switching signal ($U_{Pulse}$') at the peaks of the output voltage ($U_A$) and to which is fed the difference voltage ($\Delta U2$) between output voltage ($U_A$) and input voltage ($U_E$) which is subjected to the second bandpass filter (F2).

## Revendications

1. Procédé de reconstruction d'un signal de tension à perturbations réduites, dont la fréquence, l'amplitude et la position de phase correspondent à une tension d'entrée ($U_E$) de forme sinusoïdale, dont la fréquence, l'amplitude et/ou la position de phase sont entachées de perturbations,
la tension d'entrée ($U_E$) étant amenée vers un premier filtre passe-bande (F1) à fréquence de résonance ($f_r$) réglable, dont la tension de sortie ($U_A$) représente le signal de tension à perturbations réduites,
**caractérisé en ce que**, en déterminant une tension différentielle échantillonnée ($U_\varphi 3$) entre la tension de sortie ($U_A$) et la tension d'entrée ($U_E$) dans les passages par zéro de la tension de sortie ($U_A$), on détermine à chaque fois une grandeur de réglage ($SG(f_r)$) pour un premier régulateur (R1), lequel règle la fréquence de résonance ($f_r$) du premier filtre passe-bande (F1) de façon à ce que la tension différentielle échantillonnée ($U_\varphi 3$) dans les passages par zéro disparaisse.

2. Procédé selon la revendication 1, **caractérisé en ce que** la détermination de la tension différentielle échantillonnée ($U_\varphi 3$) entre la tension de sortie ($U_A$) et la tension d'entrée ($U_E$) dans les passages par zéro de la tension de sortie ($U_A$) est effectuée au moyen d'un premier circuit échantillonneur bloqueur (1), dont l'élément de commutation (S) est actionné par un signal de commutation ($U_{Pulse}$) dans les passages par zéro de la tension de sortie ($U_A$) et vers lequel est amenée la tension différentielle ($U_\varphi 2$) entre la tension de sortie ($U_A$) et la tension d'entrée ($U_E$), qui est soumise à un deuxième filtre passe-bande (F2).

3. Procédé selon la revendication 2, **caractérisé en ce que** la fréquence de résonance ($f_{r2}$) du deuxième filtre passe-bande (F2) est commandée par la grandeur de réglage ($SG(f_r)$) pour la fréquence de résonance ($f_r$) du premier filtre passe-bande (F1).

4. Procédé selon l'une des revendications 1 à 3, **ca-**

**ractérisé en ce que**, en déterminant la tension différentielle échantillonnée ($\Delta U3$) entre la tension de sortie ($U_A$) et la tension d'entrée ($U_E$) dans les sommets de la tension de sortie ($U_A$), on détermine une grandeur de réglage ($SG(A)$) pour un deuxième régulateur (R2), lequel règle l'amplification du premier filtre passe-bande (F1) de façon à ce que la tension différentielle échantillonnée ($\Delta U3$) dans les sommets de la tension de sortie ($U_A$) disparaisse.

5. Procédé selon la revendication 4, **caractérisé en ce que** la détermination de la tension différentielle échantillonnée ($\Delta U3$) entre la tension de sortie ($U_A$) et la tension d'entrée ($U_E$) dans les sommets de la tension de sortie ($U_A$) est effectuée au moyen d'un deuxième circuit échantillonneur bloqueur (1'), dont l'élément de commutation (S) est actionné par un signal de commutation ($U_{Pulse}$') dans les sommets de la tension de sortie ($U_A$) et vers lequel est amenée la tension différentielle ($\Delta U2$) entre la tension de sortie ($U_A$) et la tension d'entrée ($U_E$), qui est soumise à un troisième filtre passe-bande (F3).

6. Procédé selon la revendication 1 et 4, **caractérisé en ce que** la détermination de la tension différentielle échantillonnée ($U_\varphi 3$) entre la tension de sortie ($U_A$) et la tension d'entrée ($U_E$) dans les passages par zéro de la tension de sortie ($U_A$) est effectuée au moyen d'un premier circuit échantillonneur bloqueur (1), dont l'élément de commutation (S) est actionné par un signal de commutation ($U_{Pulse}$) dans les passages par zéro de la tension de sortie ($U_A$) et vers lequel est amenée la tension différentielle ($U_\varphi 2$) entre la tension de sortie ($U_A$) et la tension d'entrée ($U_E$), qui est soumise à un deuxième filtre passe-bande (F2), et dans lequel la détermination de la tension différentielle échantillonnée ($\Delta U3$) entre la tension de sortie ($U_A$) et la tension d'entrée ($U_E$) dans les sommets de la tension de sortie ($U_A$) est effectuée au moyen d'un deuxième circuit échantillonneur bloqueur (1'), dont l'élément de commutation (S) est actionné par un signal de commutation ($U_{Pulse}$') dans les sommets de la tension de sortie ($U_A$) et vers lequel est amenée la tension différentielle ($\Delta U2$) entre la tension de sortie ($U_A$) et la tension d'entrée ($U_E$), qui est soumise au deuxième filtre passe-bande (F2).

## FIG 1

FIG 2

# FIG 3

FIG 4

FIG 5

# FIG 6

# FIG 7

$U_E$

$U_A$

$U_S$

$U_{Pulse}$

$\Delta U1$

$\Delta U2$

$\Delta U3$

FIG 8

## FIG 9

**EP 2 135 352 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1047191 A1